(19) Europäisches Patentamt
European Patent Office
Office européen des brevets

(11) **EP 2 220 540 B1**

(12) **FASCICULE DE BREVET EUROPEEN**

(45) Date de publication et mention
de la délivrance du brevet:
**19.10.2011 Bulletin 2011/42**

(21) Numéro de dépôt: **08859515.2**

(22) Date de dépôt: **10.12.2008**

(51) Int Cl.:
***G04F 5/14*** *(2006.01)*     ***G01R 33/26*** *(2006.01)*

(86) Numéro de dépôt international:
**PCT/EP2008/067255**

(87) Numéro de publication internationale:
**WO 2009/074619 (18.06.2009 Gazette 2009/25)**

(54) **APPAREIL A CORRECTION DU CHAMP MAGNETIQUE AMBIANT**

VORRICHTUNG MIT UMGEBUNGSMAGNETFELDKORREKTUR

APPARATUS WITH AMBIENT MAGNETIC FIELD CORRECTION

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **11.12.2007 FR 0759742**

(43) Date de publication de la demande:
**25.08.2010 Bulletin 2010/34**

(73) Titulaire: **Commissariat à l'Énergie Atomique
et aux Énergies Alternatives
75015 Paris (FR)**

(72) Inventeurs:
• **LE PRADO, Matthieu
F-26260 Charmes Sur L'herbasse (FR)**

• **LEGER, Jean-Michel
F-38190 Villard Bonnot (FR)**

(74) Mandataire: **Ilgart, Jean-Christophe
BREVALEX
95 rue d'Amsterdam
75378 Paris Cedex 8 (FR)**

(56) Documents cités:
**EP-A- 0 964 260      FR-A- 1 354 208
JP-A- 63 191 981      US-A1- 2007 247 241**

• **HAROCHE S ET AL: "Modified Zeeman hyperfine
spectra observed in H<1> and Rb<87> ground
states interacting with a nonresonant rf field"
INSPEC,, 20 avril 1970 (1970-04-20), XP002494529**

## Description

Cette invention a trait à un appareil comprenant une correction du champ magnétique ambiant ; il est ajouté que cet appareil est utilisable dans une horloge atomique pour mesurer le temps, ou dans un magnétomètre, par une simple modification du mode d'emploi.

Des horloges atomiques comprennent un milieu gazeux souvent alcalin, un dispositif d'excitation des atomes de ce gaz tel qu'un laser, apte à les faire passer à des états d'énergie supérieurs, et un moyen de mesure d'un signal fréquentiel émis par les atomes en revenant au niveau d'énergie habituel, en utilisant les photons provenant du laser.

La fréquence du signal des photons restitués par le gaz est définie par la formule $\nu = \Delta E/h$, où $\nu$ est la fréquence, $\Delta E$ la différence entre les niveaux d'énergie et $h$ la constante de Planck, égale à $6,62 \times 10^{-34}$ J/s.

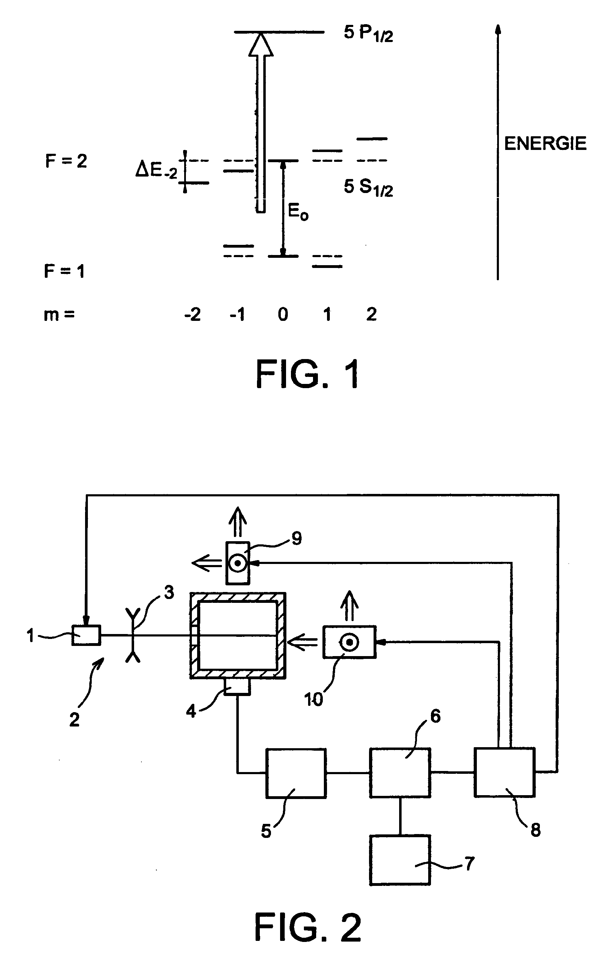

Il est connu que cette fréquence est très stable et qu'elle peut donc servir d'unité de référence au temps. Cela n'est toutefois plus vrai quand on considère la structure Zeeman de la matière : les niveaux d'énergie apparaissent alors comme composés de sous-niveaux correspondant à des états un peu différents, qu'on distingue par leur nombre quantique magnétique m, 0 pour un état de référence du niveau d'énergie et -1, -2, etc. ou +1, +2, etc. pour les autres. Cela est illustré par la figure 1 dans le cas de l'élément $^{87}$Rb, dont on a figuré la décomposition des deux premiers niveaux d'énergie (de moments angulaires F=1 et F=2).

Les niveaux d'énergie sont sensibles au champ magnétique ambiant. Cette sensibilité est faible (du second ordre) pour le sous-niveau au nombre magnétique égal à 0, mais beaucoup plus forte (du premier ordre) pour les autres sous-niveaux : les transitions faites depuis ou jusqu'à eux produisent des photons dont la fréquence est variable et ne peut donc pas servir de référence, et seule la portion du signal correspondant à la transition entre les deux sous-niveaux de nombre magnétique nul est exploitée pour la mesure, ce qui nuit à sa qualité. La fréquence de référence donnée par l'horloge est alors $fo=E_0/h$, où $E_0$ est la différence d'énergie entre les sous-niveaux à m=0 des deux états (F=1 et F=2) de l'exemple de la figure 1).

On recourt donc à un blindage magnétique autour de l'horloge pour réduire les perturbations extérieures et à l'application d'un champ magnétique constant pour bien séparer les sous-niveaux, à défaut de garantir un champ magnétique nul. Si le fonctionnement de l'horloge est rendu plus stable, les sous-niveaux étant alors immobiles et donc bien définis, l'inconvénient de subir une dispersion des fréquences et de devoir se contenter d'un signal affaibli n'est pas évité.

Avec l'invention, on s'efforce de perfectionner les horloges atomiques existantes en les faisant travailler en champ magnétique nul afin de concentrer les sous-niveaux à une même valeur d'énergie et d'obtenir un signal comprenant un pic de mesure beaucoup plus net.

Ces considérations s'appliquent sans changement à d'autres appareils et notamment à des magnétomètres, auxquels l'invention s'applique donc aussi. Elle consiste en un appareil pouvant servir d'horloge atomique ou de magnétomètre conforme aux revendications. Le document FR-A-1 354 208 mentionne le contenu du préambule de la première revendication, mais ne mentionne ni ne suggère d'agir sur les raies spectrales aux fréquences indiquées dans cette revendication pour aider à compenser un champ magnétique ambiant. De même, le document de Haroche et autres « Modified Zeeman hyperfine spectra observed in H<1> and Rb<87> ground states interacting with a nonresonant rf field », Physical review letters, vol.24, n° 16, 20 avril 1970, XP002494529 mentionne aux pages 861 à 864 diverses propriétés du pompage optique de matériaux mais rien qui évoque une compensation de champ ambiant d'après lesdites fréquences.

L'invention sera décrite de façon plus complète en liaison aux figures suivantes :

- la figure 1, déjà décrite, illustre un diagramme des niveaux d'énergie d'un élément d'une matière utilisée dans une horloge atomique ;
- la figure 2 est une vue schématique de l'horloge ;
- la figure 3 est un diagramme du signal obtenu avec l'horloge ;
- enfin, la figure 4 illustre le résultat obtenu, d'après un diagramme de niveaux d'énergie à comparer à celui de la figure 1.

Le coeur de l'horloge (figure 2) est une cellule 1 remplie d'un gaz alcalin. Un excitateur 2 transmet de l'énergie à ce gaz sous forme d'un flux de photons polarisés traversant un polariseur circulaire 3. L'excitateur peut aussi être un champ de micro-ondes par exemple. Il faudra alors de toute façons injecter un faisceau lumineux (par exemple de laser) pour détecter les résonances du gaz. Un photodétecteur 4 recueille l'énergie lumineuse restituée par le gaz de la cellule 1 et transmet un signal à un dispositif de comptage 5. Un séparateur de fréquences 6 recueille le signal à la sortie du dispositif de comptage 5 et transmet ses résultats sous forme d'un indicateur d'intensités des raies spectrales mesurées à un dispositif d'exploitation 7 de l'horloge et un dispositif d'asservissement 8, qui gouverne l'excitateur 2 ainsi que des moyens d'application de champs magnétiques 9 et 10. Ces derniers émettent des champs magnétiques à des radiofréquences de pulsations notées $\Omega$ et $\omega$, qui sont perpendiculaires entre elles et de direction dépendant de la polarisation (par exemple perpendiculaires aux rayons lumineux émis par l'excitateur 2 dans le cas d'une polarisation circulaire).

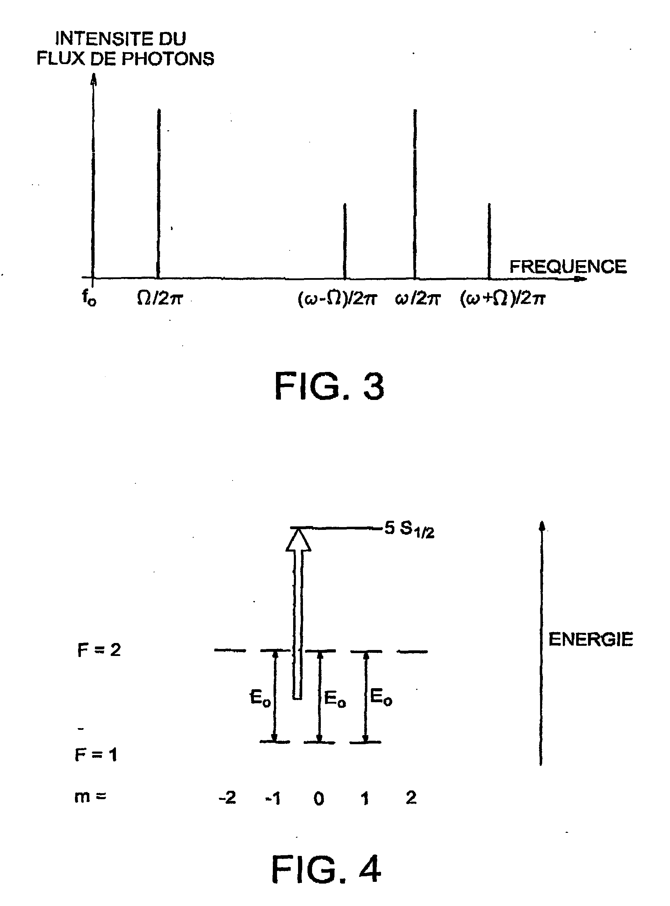

On se reporte à la figure 3. Le signal issu du dispositif de comptage 5 comprend plusieurs raies lumineuses, et d'abord une qui est à la fréquence $f_0$ utile correspondant à la restitution des photons par le milieu gazeux et qui donne la référence à la mesure de temps.

Il révèle encore des raies spectrales aux fréquences $\Omega/2\pi$, $(\omega-\Omega)/2\pi$, $\omega/2\pi$, et $(\omega+\Omega)/2\pi$. Ces raies spectrales apparaissent pour des champs magnétiques de faibles valeurs, très inférieures à $1/\delta . T_R$, où $T_R$ est le temps de relaxation des sous-niveaux et $\gamma$ est leur rapport gyromagnétique, caractéristique de l'élément chimique excité. Elles correspondent à des résonances entre les sous-niveaux. Leur amplitude est proportionnelle au champ magnétique ambiant. Il est donc conforme à l'invention d'appliquer un champ magnétique de compensation du champ magnétique ambiant essentiellement statique, mais qu'on fait varier de façon continue en amplitude et en direction si nécessaire, de façon que l'amplitude de ces raies soit réduite autant que possible, ce qui signifie que le champ de compensation a équilibré le champ magnétique ambiant. La figure 4 montre alors que les sous-niveaux de chaque niveau principal sont à une même valeur d'énergie, si bien que les photons restitués par le milieu gazeux sont tous à la fréquence $f_0$ utile : la raie spectacle correspondante apparaît sous forme d'un pic beaucoup plus fin et haut et dont la détection est donc facilitée.

Il devient possible d'omettre le blindage magnétique traditionnel des horloges atomiques, en appliquant l'invention.

Les amplitudes des champs de radiofréquences sont avantageusement choisies pour maximiser l'amplitude des raies spectrales de résonance (avant l'application du champ statique de compensation). On préconise de respecter approximativement les égalités $\gamma H\omega/\omega = 1$ et $\gamma H\Omega/\Omega = 1$, où $H\omega$ et $H\Omega$ sont les amplitudes des champs de radiofréquences de pulsations $\omega$ et $\Omega$. Avantageusement, les moyens d'application du champ magnétique sensiblement statique de compensation sont identiques à ceux qui appliquent les champs magnétiques de radiofréquences.

L'excitateur unique peut être un flux de photons tel qu'un flux de laser émis par exemple par une diode laser ou une lampe. L'élément gazeux peut consister en du $^{87}$Rb, du $^{133}$C$_s$ avec mélange éventuel à un gaz tampon. La matière de la cellule 1 peut consister en un verre tel que le Pyrex (marque déposée). Les moyens d'application des champs magnétiques 9 et 10 peuvent consister en des bobines triaxiales, ou en trois bobines monoaxiales concentriques entre elles. Le photodétecteur 4 peut être de n'importe quel genre mesurant un flux de photons en sortie de la cellule 1. Ces photons doivent être polarisés par exemple par des polariseurs adjoints à l'excitateur. L'asservissement est accompli par tout matériel connu comprenant une unité de calcul. Les bobines sont pilotées en courant ou en tension. L'excitation à la fréquence de résonance $f_0$, est accomplie par une modulation en amplitude de la diode laser à la fréquence $f_0/2$ ou par une cavité à micro-ondes résonnant à la fréquence $f_0$. Un excitateur comprenant deux lasers dont l'écart en fréquence est $f_0$ peut aussi être envisagé.

Comme tous les sous-niveaux deviennent équivalents en champ nul (indépendamment de leur valeur m), il est alors possible d'utiliser d'autres gaz que ceux habituellement utilisés (gaz alcalins) dans les horloges atomiques, en particulier les gaz dont la structure hyperfine de leurs atomes ne présente pas de sous-niveaux à moment angulaire nul, tels que $^3$He.

Dans un exemple concret où l'horloge fonctionnait avec du $^{87}$Rb, et une longueur d'onde des photons restitués de 795 nm, les champs de radiofréquences avaient des fréquences $\Omega/2\pi$ et $\omega/2\pi$ de 10 kHz et 45 kHz, et des amplitudes respectives de 15 mGauss et 70 mGauss. Avec un champ magnétique ambiant de l'ordre de 10 mGauss, la compensation était faite avec champ résiduel inférieur à 10 mGauss à chaque axe. La résolution sur le champ magnétique de compensation (bruit magnétique dû aux perturbations des moyens de commande) était de l'ordre de $0{,}1\mu\,Gauss\,/\sqrt{Hz.}$ La stabilité en fréquence de l'horloge était de l'ordre de $0{,}67\,Hz\,/\sqrt{Hz,}$ soit $10^{-10}$ /$\sqrt{\tau}$ en résolution relative sur la fréquence délivrée par l'horloge pour un temps d'intégration $\tau$.

On a décrit l'emploi de l'invention sur une horloge atomique, qui peut être à fonctionnement séquentiel ou à franges de Ramsey. Elle pourrait aussi être appliquée à la mesure de champs magnétiques, c'est-à-dire comme magnétomètre. Il suffirait de relever le champ magnétique de compensation appliqué quand les raies spectrales de la figure 5 dues aux champs à radiofréquences seraient au minimum, en le lisant sur les moyens d'application des champs magnétiques 8 et 10 : le champ magnétique ambiant serait opposé.

Il est intéressant de constater que le champ vu par les atomes étant nul, un blindage magnétique s'avère superflu.

## Revendications

1. Appareil comprenant une cellule (1) remplie d'un gaz, un excitateur (2) du gaz pour faire passer ses atomes à un niveau d'énergie supérieur, un détecteur (4) pour recueillir un signal lumineux traversant le gaz, comprenant des moyens d'application de champs magnétiques (9, 10), appliquant un champ magnétique essentiellement statique et deux champs magnétiques oscillants et dirigés perpendiculairement entre eux, et comprenant des moyens d'asservissement (8) des moyens d'application de champs magnétiques pour régler en direction et en intensité le champ magnétique essentiellement statique, qui est un champ magnétique de compensation d'un champ magnétique ambiant, **caractérisé en ce que** lesdits moyens d'asservissement sont agencés de façon à réduire l'amplitude de raies spectrales du signal lumineux traversant le gaz par-

mi les fréquences ( $\frac{\Omega}{2\pi}$ , $\frac{\omega}{2\pi}$ ) des champs magnétiques oscillants, la somme ( $\frac{\omega+\Omega}{2\pi}$ ) desdites fréquences et la différence ( $\frac{\omega-\Omega}{2\pi}$ ) desdites fréquences.

2. Appareil selon la revendication 1, **caractérisé en ce qu'**il est une horloge atomique.

3. Appareil selon la revendication 1, **caractérisé en ce qu'**il est un magnétomètre.

4. Appareil selon l'une quelconque des revendications 1 à 3, **caractérisé en ce que** les moyens d'application de champs magnétiques comprennent au moins une bobine triaxiale magnétique.

5. Appareil selon l'une quelconque des revendications 1 à 3, **caractérisé en ce que** les moyens d'application de champs magnétiques comprennent au moins trois bobines monoaxiales concentriques.

6. Appareil selon les revendications précédentes **caractérisé en ce que** le gaz est choisi parmi les gaz alcalins et l'hélium 3.

7. Appareil selon l'une quelconque des revendications 1 à 6, **caractérisé en ce qu'**il est dépourvu de blindage magnétique.

8. Appareil selon la revendication 1, **caractérisé en ce que** les champs oscillants ont des intensités (Hω, HΩ) égales à des pulsations (ω,Ω) respectives desdits champs oscillants, divisées par un rapport gyromagnétique du gaz.

**Claims**

1. Apparatus comprising a cell (1) filled with a gas, an exciter (2) of the gas to make its atoms jump to a higher energy lever, a detector (4) to collect a light signal passing through the gas, comprising means for applying magnetic fields (9, 10), applying an essentially static magnetic field and two oscillating magnetic fields directed perpendicular to each other, and comprising means for controlling (8) the means for applying magnetic fields to regulate in direction and in intensity the essentially static magnetic field, which is a magnetic field compensating an ambient magnetic field, **characterized in that** the means for controlling are arranged to reduce the amplitude of spectral lines of the light signal passing through the gas among the frequencies $\left( \frac{\Omega}{2\pi}, \frac{\omega}{2\pi} \right)$ of the oscillating magnetic fields, the sum of said frequencies $\left( \frac{\omega+\Omega}{2\pi} \right)$ or the difference $\left( \frac{\omega-\Omega}{2\pi} \right)$ of said frequencies.

2. Apparatus according to claim 1, **characterised in that** it is an atomic clock.

3. Apparatus according to claim 1, **characterised in that** it is a magnetometer.

4. Apparatus according to any of claims 1 to 3, **characterised in that** the means for applying magnetic fields comprise at least one triaxial magnetic coil.

5. Apparatus according to any of claims 1 to 3, **characterised in that** the means for applying magnetic fields comprise at least three concentric monoaxial coils.

6. Apparatus according to the preceding claims, **characterised in that** the gas is chosen among alkaline gases and helium 3.

7. Apparatus according to any of claims 1 to 6, **characterised in that** it is devoid of magnetic shielding.

8. Apparatus according to claim 1, **characterised in that** the oscillating fields have intensities (Hω, HΩ) equal to respective pulsations (ω,Ω) of said oscillating fields, divided by a gyromagnetic ratio of the gas.

**Patentansprüche**

1. Gerät mit einer mit einem Gas gefüllten Zelle (1), einem Erreger (2) für das Gas, um dessen Atome auf ein höheres Energieniveau zu bringen, einem Detektor (4) zum Aufnehmen eines das Gas durchlaufenden Lichtsignals, mit Mitteln zum Anlegen von Magnetfeldern (9, 10), die ein im Wesentlichen statisches Magnetfeld sowie zwei schwingende und senkrecht zueinander gerichtete Magnetfelder anlegen, und mit Mitteln zum Regeln (8) der Mittel zum Anlegen von Magnetfeldern, um das im Wesentlichen statische Magnetfeld, das ein Magnetfeld zum Ausgleichen eines Umgebungsmagnetfeldes ist, hinsichtlich Richtung und Stärke einzustellen, **dadurch gekennzeichnet, dass** die Regelungsmittel derart angeordnet sind, dass die Spektrallinienamplitude des das Gas durchlaufenden Lichtsignals un-

ter den Frequenzen $(\frac{\Omega}{2\pi}, \frac{\omega}{2\pi})$ der schwingenden Magnetfelder, der Summe $(\frac{\omega + \Omega}{2\pi})$ der Frequenzen und der Differenz $(\frac{\omega - \Omega}{2\pi})$ der Frequenzen reduziert wird.

2. Gerät nach Anspruch 1, **dadurch gekennzeichnet, dass** es eine Atomuhr ist.

3. Gerät nach Anspruch 1, **dadurch gekennzeichnet, dass** es ein Magnetometer ist.

4. Gerät nach einem der Ansprüche 1 bis 3, **dadurch gekennzeichnet, dass** die Mittel zum Anlegen von Magnetfeldern wenigstens eine dreiachsige Magnetspule umfassen.

5. Gerät nach einem der Ansprüche 1 bis 3, **dadurch gekennzeichnet, dass** die Mittel zum Anlegen von Magnetfeldern wenigstens drei konzentrische einachsige Spulen umfassen.

6. Gerät nach den vorhergehenden Ansprüchen, **dadurch gekennzeichnet, dass** das Gas aus den alkalischen Gasen und Helium-3 ausgewählt ist.

7. Gerät nach einem der Ansprüche 1 bis 6, **dadurch gekennzeichnet, dass** es keine magnetische Abschirmung aufweist.

8. Gerät nach Anspruch 1, **dadurch gekennzeichnet, dass** die schwingenden Feder Stärken (H$\omega$, H$\Omega$) aufweisen, die gleich jeweiligen Schwingungen ($\square$, $\Omega$) der schwingenden Felder, geteilt durch ein gyromagnetisches Verhältnis des Gases sind.

FIG. 1

FIG. 2

INTENSITE DU
FLUX DE PHOTONS

FREQUENCE

$f_o$     $\Omega/2\pi$         $(\omega-\Omega)/2\pi$   $\omega/2\pi$   $(\omega+\Omega)/2\pi$

## FIG. 3

$5\,S_{1/2}$

F = 2

$E_o$   $E_o$   $E_o$

F = 1

m =    -2   -1   0   1   2

ENERGIE

## FIG. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1354208 A

**Littérature non-brevet citée dans la description**

- **HAROCHE.** Modified Zeeman hyperfine spectra observed in H<1> and Rb<87> ground states interacting with a nonresonant rf field. *Physical review letters,* 20 Avril 1970, vol. 24 (16), 861-864